# EUROPEAN PATENT APPLICATION

(11) **EP 1 182 468 A2**
(43) Date of publication of application: **27.02.2002**
(21) Application number: 00121788.4
(22) Date of filing: 05.10.2000
(51) Int. Cl.: G02B 5/18, G03F 7/20

(54) **Method for forming grating pattern on glass substrate**

(30) Priority: 22.08.2000 KR 0048503
(71) Applicant: HAVIT Co., Ltd., Suite 6114 TBI Center, Daejeon (KR)
(72) Inventor: Park, Byung-Sun, Daejeon (KR); Kwon, Kwang-Ho, Daejeon (KR)
(74) Representative: Betten & Resch

(57) **Abstract**

The present invention relates to a method for forming a grating pattern on a glass substrate. The method is to stabilize an etched surface of a glass substrate, thereby preventing a deformation of the surface or an attachment of an adhesive on the surface and thusly increasing a productive yield when manufacturing an optical component. There is provided the method for forming a grating pattern on a glass substrate, comprising steps of forming a photoresist pattern on the glass substrate using a lithographic technology, wet-etching the glass substrate using a HF-mixed solution, and forming a grating pattern, and removing the photoresist pattern using a solution for stripping a photoresist film, and finally stabilizing a surface of the etched glass substrate.

## Description

### BACKGROUND OF THE INVENTION

### 1. Field of the Invention

The present invention relates to a method for forming a grating pattern on a glass substrate.

### 2. Description of the Related Art

Generally, a grating pattern formed on a transparent glass substrate is widely used in a diffraction grating for an optical pick-up. The diffraction grating on the glass substrate is formed in the shape of a periodic and rectangular pattern, that is, a periodic grating pattern. The diffraction grating is served as an optical component to divide a laser beam into 3 beams, that is, 0^{th} and ± 1^{st} beams at a constant ratio. In a conventional method for forming a grating pattern, a transparent thin film such as an oxide film or SOG (Spin On Glass) thin film is formed on a glass substrate. Using the thin film, the grating pattern has been formed. A typical process for forming the grating pattern on the glass substrate is described below.

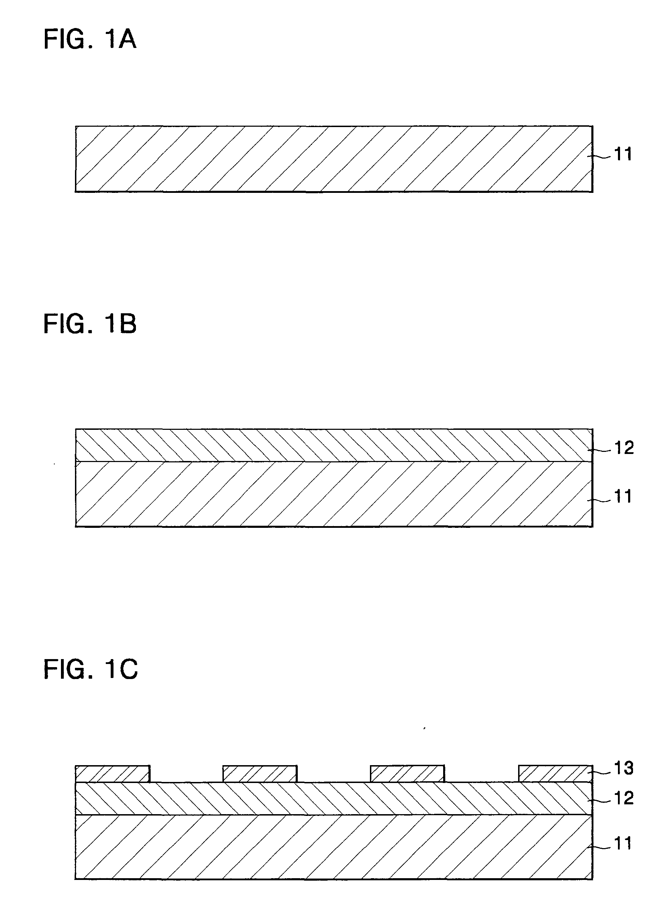

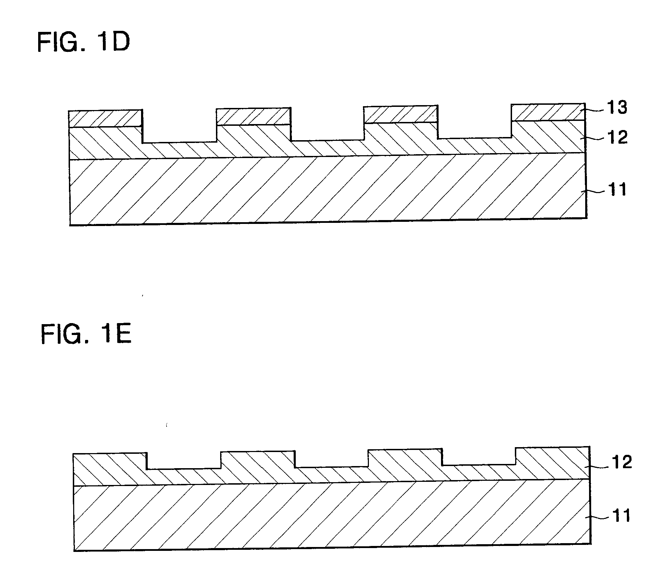

Fig. 1A shows a cross-sectional view of a glass substrate for forming a grating pattern according to a conventional art, and Fig. 1B shows a cross-sectional view of the glass substrate on which a thin film is formed according to the conventional art. A thin film 12 is formed on a glass substrate 11 of Fig. 1A by a sputtering or SOG coating method, as shown in Fig. 1B. Fig. 1C shows a cross-sectional view of a process for forming a photoresist pattern according to the conventional art, and Fig. 1D shows a cross-sectional view of a process for forming a grating pattern according to the conventional art. As shown in Fig. 1C, a photoresist pattern 13 is formed on the thin film 12 by a lithographic technology. The glass substrate, on which the photoresist pattern 13 is formed, is etched in a HF-mixed solution so as to form a grating pattern as shown in Fig. 1D. Fig. 1E is a cross-sectional view showing a process for stripping the photoresist pattern according to the conventional art. As shown in Fig. 1E, the glass substrate is then dipped into a stripping solution so as to strip the photoresist pattern 13 and complete the gating pattern.

Meanwhile, in the conventional processes as described above, there are some problems that a certain equipment and a material are required to deposite the thin film on the glass substrate, and a productivity of the completed grating may decrease due to the non-uniformity of a thickness when forming the thin film. Further, in case an adhesion between the thin film and the glass substrate is not good, the thin film may be easily peeled from the glass substrate. Moreover, since the thin film formed by depositing and coating processes has a rougher surface than the glass substrate, optical performance of the diffraction grating is made worse due to the surface roughness of the thin film.

### SUMMARY OF THE INVENTION

Accordingly, it is an object of the present invention to etch a glass substrate by using a photoresist pattern, and to stabilize a surface of the etched glass substrate, thereby preventing a deformation of the surface or an attachment of an adhesive on the etched surface of the glass substrate and thus increasing a productive yield when manufacturing an optical component.

It is other object of the present invention to stabilize the surface of the glass substrate using one or a mixture of acid solutions, a solution mixed with the acid solutions, H₂O₂, and alcohol, thereby suppress s a deformation on the glass substrate.

According to a first aspect of the present invention, there is provided a method for forming a grating pattern on a glass substrate, comprising steps of (a) forming a photoresist pattern on the glass substrate using a lithographic technology; (b) wet-etching the glass substrate using HF-mixed solutions and forming the grating pattern; (c) removing the photoresist pattern using a solution for stripping the photoresist film; and (d) stabilizing a etched surface of the glass substrate.

According to a second aspect of the present invention, the step (d) comprises steps of (d-1) dipping the glass substrate in a stabilizing solution at a predetermined temperature for a predetermined time; (d-2) rinsing the glass substrate with Dl water; and (d-3) drying the glass substrate with an N₂ gun or a spin dryer.

According to a third aspect of the present invention, the step (d) comprises a step (d-1) of thermal-treating the glass substrate in a stabilizing gas atmosphere at a predetermined temperature.

According to a fourth aspect of the present invention, the step (d) comprises a step (d-1) of depositing a transparent thin film on the glass substrate.

According to a fifth aspect of the present invention, the step (d) further comprises a step (d-4) of thermal-treating the glass substrate in a stabilizing gas atmosphere at a predetermined temperature.

According to a sixth aspect of the present invention, the step (d) further comprises a step (d-4) of depositing a transparent thin film on the glass substrate.

According to a seventh aspect of the present invention, the step (d) further comprises a step (d-2) of depositing a transparent thin film on the glass substrate.

According to an eighth aspect of the present invention, the step (d) further comprises a step (d-5) of depositing a transparent thin film on the glass substrate.

According to a ninth aspect of the present invention, the stabilizing solution of the step (d-1) is one or a mixture of acid solutions, a solution mixed with the acid solutions, H₂O₂, and alcohol; and the temperature of the stabilizing solution is 25°C ∼ 600°C.

According to a tenth aspect of the present invention, the stabilizing gas of the stabilizing gas atmosphere of the step (d) is one or a mixture of N₂, O₂, and Ar; and the temperature of the stabilizing gas atmosphere is 25°C ∼ 600°C.

According to a eleventh aspect of the present invention, the stabilizing solution of the step (d-1) is one or a mixture of an acid solution, a solution mixed with the acid solution, H₂O₂, and alcohol, and the temperature of the stabilizing solution is 25°C ∼ 600°C; and the stabilizing gas of the stabilizing gas atmosphere of the step (d) is one or a mixture of N₂, O₂, and Ar, and the temperature of the stabilizing gas atmosphere is 25°C ∼ 600°C.

According to a twelfth aspect of the present invention, there is provided a method for forming a grating pattern on a glass substrate, comprising steps of (a) forming a photoresist pattern on the glass substrate using a lithographic technology; (b) wet-etching the glass substrate using a stabilizing HF-mixed solution, thereby forming the grating pattern, and stabilizing a surface of the glass substrate; and (c) removing the photoresist pattern using a solution for stripping a photoresist film.

According to a thirteenth aspect of the present invention, the method further comprises a step (d) of thermal-treating the glass substrate in a stabilizing gas atmosphere at a predetermined temperature.

According to a fourteenth aspect of the present invention, the method further comprises a step (d) of depositing a transparent thin film on the glass substrate.

According to a fifteenth aspect of the present invention, the method further comprises a step (e) of depositing a transparent thin film on the glass substrate.

According to a sixteenth aspect of the present invention, the stabilizing HF-mixed solution of the step (b) is a solution which is mixed with the HF-mixed solution and the stabilizing solution; the stabilizing solution is one or a mixture of an acid solution, a solution mixed with the acid solution, H₂O₂ and alcohol; and the temperature of the stabilizing solution is 25°C ∼ 600°C.

According to a seventeenth aspect of the present invention, the stabilizing gas of the stabilizing gas atmosphere of the step (d) is one or a mixture of N₂, O₂, and Ar, and the temperature of the stabilizing gas atmosphere is 25°C ∼ 600°C.

According to a eighteenth aspect of the present invention, the stabilizing HF-mixed solution of the step (b) is a solution which is mixed with the HF-mixed solution and the stabilizing solution, the stabilizing solution is one or a mixture of an acid solution, a solution mixed with the acid solution, H₂O₂ and alcohol, and the temperature of the stabilizing solution is 25°C ∼ 600°C; and the stabilizing gas of the stabilizing gas atmosphere of the step (d) is one or a mixture of N₂, O₂, and Ar, and the temperature of the stabilizing gas atmosphere is 25°C ∼ 600°C.

### BRIEF DESCRIPTION OF THE DRAWINGS

Fig. 1A is a cross-sectional view of a glass substrate for forming a grating pattern according to a conventional art;
Fig. 1B is a cross-sectional view of the glass substrate on which a thin film is formed according to the conventional art;
Fig. 1C is a cross-sectional view showing a process for forming a photoresist pattern according to the conventional art;
Fig. 1D is a cross-sectional view showing a process for forming a grating pattern according to the conventional art;
Fig. 1E is a cross-sectional view showing a process for stripping the photoresist pattern according to the conventional art;
Fig. 2A is a cross-sectional view of a glass substrate for forming a grating pattern according to the present invention;
Fig. 2B is a cross-sectional view of the glass substrate on which a photoresist pattern is formed according to the present invention;
Fig. 2C is a cross-sectional view showing a process for forming a grating pattern according to the present invention;
Fig. 2D is a cross-sectional view showing a process for stripping the photoresist pattern according to the present invention;
Fig. 2E is a cross-sectional view showing a process for stabilizing the glass substrate using a stabilizing solution according to the present invention;
Fig. 2F is a cross-sectional view showing a process for stabilizing the glass substrate using a gas according to the present invention;
Fig. 2G is a cross-sectional view showing a process for forming a transparent thin film according to the present invention;
Fig. 3A is a cross-sectional view of a glass substrate for forming a grating pattern according to the present invention;
Fig. 3B is a cross-sectional view of the glass substrate on which a photoresist pattern is formed according to the present invention;
Fig. 3C is a cross-sectional view showing a process for forming the grating pattern and, at the same time, stabilizing the glass substrate using a stabilizing HF-mixed solution according to the present invention;
Fig. 3D is a cross-sectional view showing a process for stripping the photoresist pattern according to the present invention;
Fig. 3E is a cross-sectional view showing a process for stabilizing the glass substrate using a gas according to the present invention; and
Fig. 3F is a cross-sectional view showing a process for depositing a transparent thin film according to the present invention.

### DETAILED DESCRIPTION OF THE PREFERRED EMBODIMENTS

The objects, characteristics and advantages of the above-described invention will become more apparent by describing the preferred embodiments thereof with reference to the accompanying drawings.

### First Embodiment

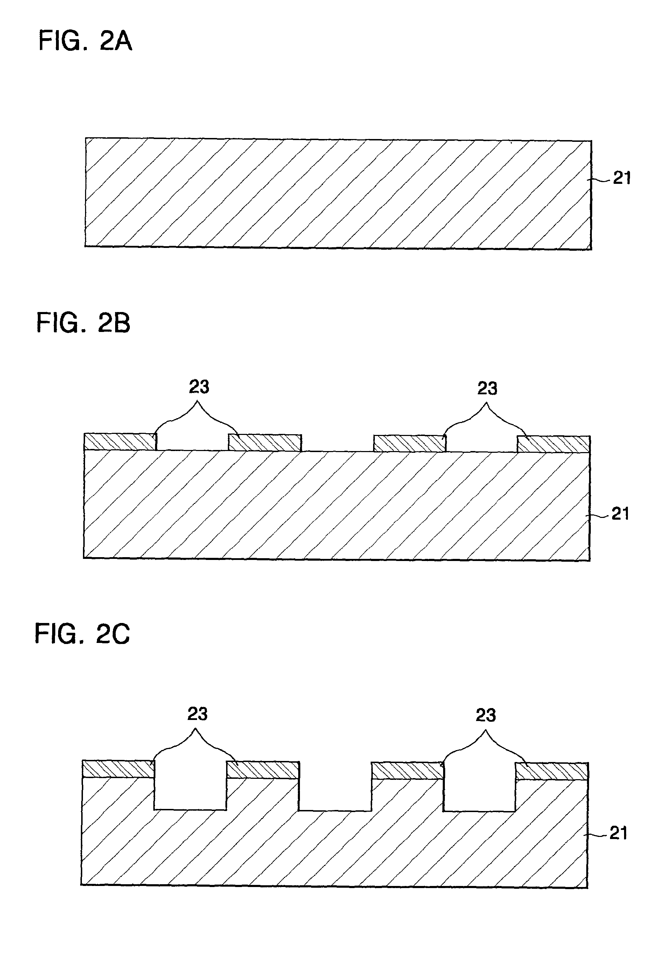

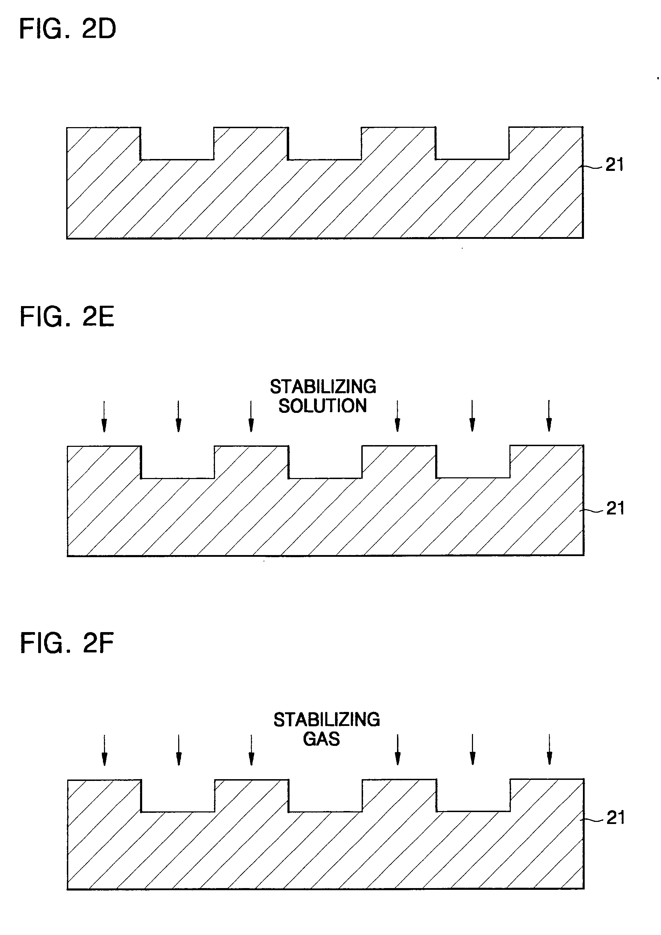

Fig. 2A is a cross-sectional view of a glass substrate for forming a grating pattern according to the present invention and Fig. 2B is a cross-sectional view of the glass substrate on which a photoresist pattern is formed according to the present invention. On a glass substrate 21 of Fig. 2A, there is not formed a thin film. A photoresist pattern 23 is formed on the glass substrate 21 by the lithographic technology as shown in Fig. 2B. Fig. 2C is a cross-sectional view showing a process for forming a grating pattern according to the present invention and Fig. 2D is a cross-sectional view showing a process for stripping the photoresist pattern according to the present invention. In a situation shown in Fig. 2B, if using a HF-mixed solution to wet-etch the glass substrate 21, a grating pattern is formed on the glass substrate 21 as shown in Fig. 2C. Then, the photoresist pattern 23 is removed by a solution for stripping a photoresist film. Therefore, the grating pattern is completed as shown in Fig. 2D. However, if an adhesive was used to attach the diffraction grating formed by the above processes to an optical component, optical characteristics are changed, whereby the performance of the diffraction grating is made worse. Therefore, in order to prevent this problem, the etched glass substrate 21 is stabilized using one or a mixture of an acid solution, a solution mixed with the acid solution, H₂O₂ and alcohol (hereinafter, it is called "stabilizing solution") as shown in Fig. 2E. Fig. 2E is a cross-sectional view showing a process for stabilizing the glass substrate using a stabilizing solution according to the present invention. The etched glass substrate 21 is dipped into the stabilizing solution at a predetermined temperature (25°C ∼ 600°C) for a predetermined time. After stabilizing a surface of the etched glass substrate 21 using the stabilizing solution, the glass substrate 21 is rinsed with DI water and dried by a N₂ gun or a spin dryer (not shown).

### Second Embodiment

In the second embodiment of the present invention, the processes of Fig. 2A to 2D are the same as those in the first embodiment. As mentioned above, if an adhesive is used to attach the diffraction grating formed by the above processes through Fig. 2A to 2D to an optical component, optical characteristics are changed, whereby the performance of the diffraction grating is made worse. Fig. 2F is a cross-sectional view showing a process for stabilizing the glass substrate using a gas according to the present invention. In order to stabilize the surface of the glass substrate, the etched glass substrate 21 is thermal-treated in a gas atmosphere of one or a mixture of N₂, O₂, and Ar (hereinafter, it is called "stabilizing gas atmosphere), and the temperature of the stabilizing gas atmosphere at a temperature of 25°C ∼ 600°C as shown in Fig. 2F.

### Third Embodiment

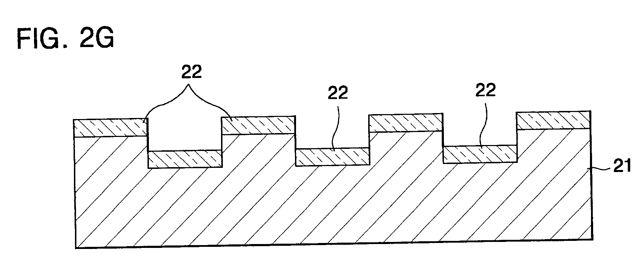

In the third embodiment of the present invention, the processes of Fig. 2A to 2D are the same as those in the first embodiment. As mentioned above, if an adhesive is used to attach the diffraction grating formed by the above processes through Fig. 2A to 2D to an optical component, optical characteristics are changed, whereby the performance of the diffraction grating is made worse. Fig. 2G is a cross-sectional view showing a process for depositing a transparent thin film according to the present invention. After the grating pattern is completely formed as shown in Fig. 2D of the first embodiment, a transparent thin film is deposited on the etched glass substrate to prevent a reaction of adhesives on the surface of the etched glass substrate as shown in Fig. 2G. Therefore, when the adhesive is used, the adhesive is isolated from the surface of the glass substrate by the transparent thin film.

### Fourth Embodiment

The fourth embodiment is a combination of processes of the first and second embodiments. That is, after performing the stabilizing process of the first embodiment, another stabilizing process of the second embodiment is carried out again. In other words, in the fourth embodiment, the processes from Fig. 2A to 2D are the same as those in the first embodiment. In case the adhesive is used to attach the diffraction grating formed by the above processes to the optical component, optical characteristics are changed, whereby the performance of the diffraction grating is made worse. Therefore, in order to prevent this problem, the etched glass substrate 21 is dipped into the stabilizing solution at a predetermined temperature (25°C ∼ 600°C) for a predetermined time as shown in Fig. 2E. After stabilizing the surface of the etched glass substrate 21 using the stabilizing solution, the glass substrate 21 is rinsed with the DI water and dried by the N₂ gun or a spin dryer (not shown). And then, as shown in Fig. 2F, the etched glass substrate 21 is thermal-treated in a stabilizing gas atmosphere at a temperature of 25°C ∼ 600°C so that the surface of the glass substrate is stabilized once more.

### Fifth Embodiment

The fifth embodiment is a combination of processes of the first and third embodiments. That is, after firstly performing the stabilizing process of the first embodiment, another stabilizing process of the third embodiment is secondly carried out. In other words, in the fifth embodiment, the processes of Fig. 2A to 2D are the same as those in the first embodiment. In case the adhesive is used to attach the diffraction grating formed by the above processes to the optical component, optical characteristics are changed, whereby the performance of the diffraction grating is made worse. Therefore, in order to prevent this problem, the etched glass substrate 21 is dipped into the stabilizing solution at a predetermined temperature (25°C ∼ 600°C) for a predetermined time as shown in Fig. 2E. After stabilizing the surface of the glass substrate 21 using the stabilizing solution, the glass substrate 21 is rinsed with the DI water and dried by the N₂ gun or a spin dryer (not shown). And then, as shown in Fig. 2G, a transparent thin film is deposited on the etched glass substrate to prevent the reaction of the adhesive on the surface of the etched glass substrate. Therefore, when the adhesive is used, the adhesive is isolated from the surface of the glass substrate by the transparent thin film.

### Sixth Embodiment

The sixth embodiment is a combination of processes of the second and third embodiments. That is, after performing the stabilizing process of the second embodiment, another stabilizing process of the third embodiment is carried out again. In other words, in the sixth embodiment, the processes of Fig. 2A to 2D are the same as those in the first embodiment. In case the adhesive is used to attach the grating pattern formed by the above processes to the optical component, optical characteristics are changed, whereby the performance of the diffraction grating is made worse. Therefore, in order to prevent this problem, the etched glass substrate 21 is thermal-treated in a stabilizing gas atmosphere at a temperature of 25°C ∼ 600°C as shown in Fig. 2F. And then, as shown in Fig. 2G, a transparent thin film is deposited on the etched glass substrate to prevent the reaction of the adhesive on the surface of the etched glass substrate. Therefore, when the adhesive is used, the adhesive is isolated from the surface of the glass substrate by the transparent thin film.

### Seventh Embodiment

The seventh embodiment is a combination of processes of the first, second and third embodiments. That is, after performing the stabilizing process of the first embodiment, another stabilizing process of the second embodiment is carried out again and further stabilizing process of the third embodiment is performed once again. In other words, in the seventh embodiment, the processes of Fig. 2A to 2D are the same as those in the first embodiment. In case the adhesive is used to attach the diffraction grating formed by the above processes to the optical component, optical characteristics are changed, whereby the performance of the diffraction grating is made worse. Therefore, in order to prevent this problem, the etched glass substrate 21 is dipped into the stabilizing solution at a predetermined temperature (25°C ∼ 600°C) for a predetermined time as shown in Fig. 2E. After stabilizing the surface of the etched glass substrate 21 using the stabilizing solution, the glass substrate 21 is rinsed with the Dl water and dried by the N₂ gun or a spin dryer (not shown). And then, as shown in Fig. 2F, the etched glass substrate 21 is thermal-treated in a stabilizing gas atmosphere at a temperature of 25°C ∼ 600°C so that the surface of the glass substrate is stabilized once more. Finally, as shown in Fig. 2G, a transparent thin film is deposited on the etched glass substrate to prevent the reaction of the adhesive on the surface of the etched glass substrate. Therefore, when the adhesive is used, the adhesive is isolated from the surface of the glass substrate by the transparent thin film.

### Eighth Embodiment

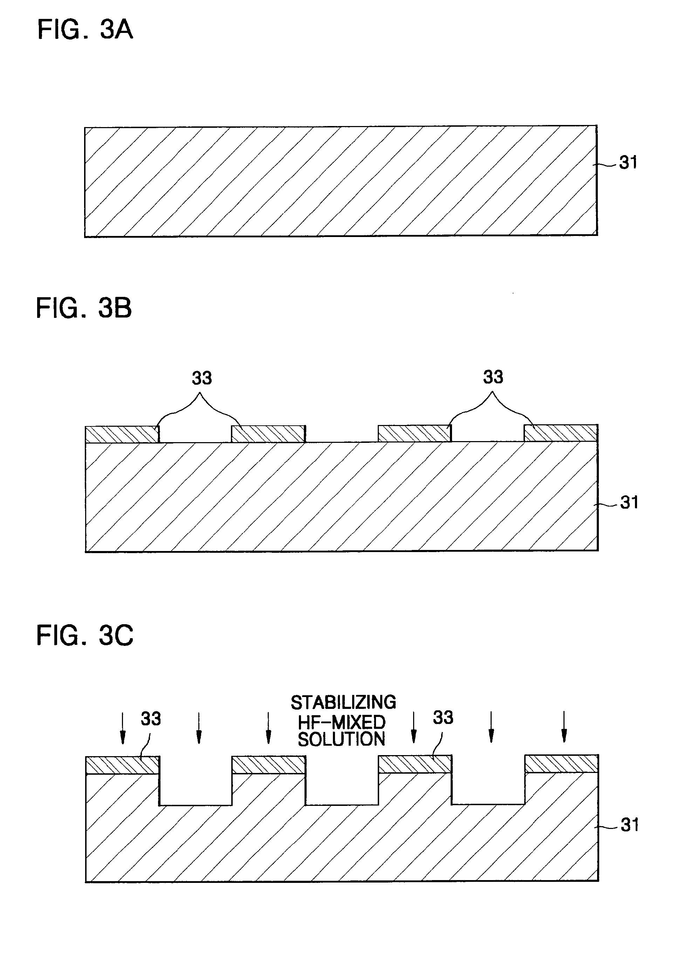

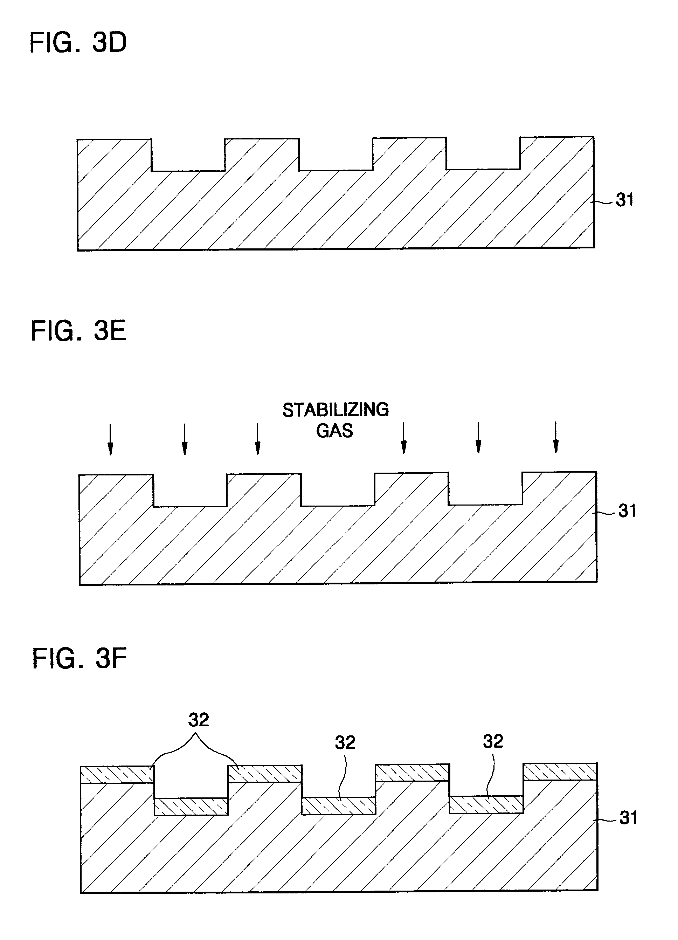

Fig. 3A is a cross-sectional view of a glass substrate for forming a grating pattern according to the present invention and Fig. 3B is a cross-sectional view of the glass substrate on which a photoresist pattern is formed according to the present invention. On a glass substrate 21 of Fig. 3A, there is not formed a thin film. A photoresist pattern 23 is formed on the glass substrate 21 by the lithographic technology as shown in Fig. 3B. Fig. 3C is a cross-sectional view showing a process for forming the grating pattern and, at the same time, stabilizing the glass substrate using a stabilizing HF-mixed solution according to the present invention and Fig. 3D is a cross-sectional view showing a process for stripping the photoresist pattern according to the present invention. In the embodiment, the surface of the etched glass substrate is wet-etched and also stabilized for a predetermined time at a predetermined temperature (25°C ∼ 600°C) using a solution mixed with the HF-mixed solution and the stabilizing solution (hereinafter, it is called "stabilizing HF-mixed solution") as well as the HF-mixed solution. Thus, a grating pattern as shown in Fig. 3C is formed. And then, the photoresist pattern 33 is removed by a solution for stripping the photoresist film, whereby the grating pattern is completed as shown in Fig. 3D.

That is, in the eighth embodiment, the process of Fig. 2C of the first embodiment is simultaneously carried out along with the stabilizing process of Fig. 2E. In other words, the processes of Fig. 3A to 3B are the same as those of Fig. 2A to 2B of the first embodiment. However, in the process of Fig. 3C of the embodiment, the processes of forming the grating pattern and stabilizing the surface of the etched glass substrate are simultaneously carried out using the stabilizing HF-mixed solution instead of the HF-mixed solution.

### Ninth Embodiment

The ninth embodiment of the present invention is a combination of processes of the eighth and second embodiments. In the embodiment, the processes of Fig. 3A to 3D are the same as those in the eighth embodiment. That is, after performing the processes of the eighth embodiment, the stabilizing process of the second embodiment is carried out again. In other words, after the process of Fig. 3D, the glass substrate 31 is thermal-treated in a stabilizing gas atmosphere at a temperature of 25°C ∼ 600°C so as to stabilize the surface of the glass substrate as shown in Fig. 3E. Therefore, the glass substrate is completely stabilized. Fig. 3E is a cross-sectional view showing a process for stabilizing the glass substrate using a gas according to the present invention.

### Tenth Embodiment

The tenth embodiment of the present invention is a combination of processes of the eighth and third embodiments. In the embodiment, the processes of Fig. 3A to 3D are the same as those in the eighth embodiment. That is, after performing the processes of the eighth embodiment, the stabilizing process of the third embodiment is carried out again. In other words, after the process of Fig. 3D, a transparent thin film is deposited on the glass substrate as shown in Fig. 3F. Therefore, the glass substrate is completely stabilized. Thus, when the adhesive is used, the adhesive is isolated from the surface of the glass substrate by the transparent thin film. Fig. 3F is a cross-sectional view showing a process for forming a transparent thin film according to the present invention.

### Eleventh Embodiment

The eleventh embodiment of the present invention is a combination of processes of the eighth, second and third embodiments. In the embodiment, the processes of Fig. 3A to 3D are the same as those in the eighth embodiment. That is, after performing the processes of the eighth embodiment, the stabilizing process of the second embodiment is carried out again and another stabilizing process of the third embodiment is carried out once again. In other words, after the process of Fig. 3D, the glass substrate 31 is thermal-treated in a stabilizing gas atmosphere at a temperature of 25°C ∼ 600°C so as to stabilize the surface of the glass substrate as shown in Fig. 3E so that the glass substrate is stabilized. And then, a transparent thin film is deposited on the glass substrate as shown in Fig. 3F. Therefore, the glass substrate is completely stabilized. Thus, when the adhesive is used, the adhesive is isolated from the surface of the glass substrate by the transparent thin film.

As described above, according to the present invention, the performance lowering of the diffraction grating due to the change in optical characteristics caused by the adhesive when an optical component is fabricated is prevented by the processes after etching the glass substrate. Further, the thin film forming process for fabricating the diffraction grating is not needed. As the result, an additional equipment and a material for forming the thin film is not also needed, and manufacturing cost is lowered. In addition, since the process for forming the thin film is eliminated, the manufacturing processes are also simplified and the performance lowering of the diffraction grating due to the thin film is thoroughly prevented.

Although the preferred embodiment of the present invention have been disclosed for illustrative purposes, those skilled in the art will appreciate that various modifications, additions and substitutions are possible, without departing from the scope and spirit of the invention.

## Claims

1. A method for forming a grating pattern on a glass substrate, comprising steps of:
(a) forming a photoresist pattern on said glass substrate using a lithographic technology;
(b) wet-etching said glass substrate using HF-mixed solutions and forming said grating pattern;
(c) removing said photoresist pattern using a solution for stripping a photoresist film; and
(d) stabilizing an etched surface of said glass substrate.

2. The method of Claim 1, wherein said step (d) comprises steps of:
(d-1) dipping said glass substrate in a stabilizing solution at a predetermined temperature for a predetermined time;
(d-2) rinsing said glass substrate with DI water; and
(d-3) drying said glass substrate with an N₂ gun or a spin dryer.

3. The method of Claim 1, wherein said step (d) comprises a step (d-1) of thermal-treating said glass substrate in a stabilizing gas atmosphere at a predetermined temperature.

4. The method of Claim 1, wherein said step (d) comprises a step (d-1) of depositing a transparent thin film on said glass substrate.

5. The method of Claim 2, wherein said step (d) further comprises a step (d-4) of thermal-treating said glass substrate in a stabilizing gas atmosphere at a predetermined temperature.

6. The method of Claim 2, wherein said step (d) further comprises a step (d-4) of depositing a transparent thin film on said glass substrate.

7. The method of Claim 3, wherein said step (d) further comprises a step (d-2) of depositing a transparent thin film on said glass substrate.

8. The method of Claim 5, wherein said step (d) further comprises a step (d-5) of depositing a transparent thin film on said glass substrate.

9. The method of any one of Claims 2, 5, 6 and 8, wherein said stabilizing solution of said step (d-1) is one or a mixture of an acid solution, a solution mixed with the acid solution, H₂O₂, and alcohol; and the temperature of said stabilizing solution is 25°C ∼ 600°C.

10. The method of any one of Claims 3, 5, 7 and 8, wherein the stabilizing gas of said stabilizing gas atmosphere of said step (d) is one or a mixture of N₂, O₂, and Ar; and the temperature of said stabilizing gas atmosphere is 25°C ∼ 600°C.

11. The method of Claim 5 or 8, wherein said stabilizing solution of said step (d-1) is one or a mixture of an acid solution, a solution mixed with the acid solution, H₂O₂, and alcohol, and the temperature of said stabilizing solution is 25°C ∼ 600°C; and
the stabilizing gas of said stabilizing gas atmosphere of said step (d) is one or a mixture of N₂, O₂, and Ar, and the temperature of said stabilizing gas atmosphere is 25°C ∼ 600°C.

12. A method for forming a grating pattern on a glass substrate, comprising steps of:
(a) forming a photoresist pattern on said glass substrate using a lithographic technology;
(b) wet-etching said glass substrate using a stabilizing HF-mixed solution thereby forming said grating pattern and stabilizing a surface of said glass substrate; and
(c) removing said photoresist pattern using a solution for stripping a photoresist film.

13. The method of Claim 12, further comprising a step (d) of thermal-treating said glass substrate in a stabilizing gas atmosphere at a predetermined temperature.

14. The method of Claim 12, further comprising a step (d) of depositing a transparent thin film on said glass substrate.

15. The method of Claim 13, further comprising a step (e) of depositing a transparent thin film on said glass substrate.

16. The method of any one of Claims 12, 13, 14 and 15, wherein said stabilizing HF-mixed solution of said step (b) is a solution which is mixed with the HF-mixed solution and the stabilizing solution; said stabilizing solution is one or a mixture of an acid solution, a solution mixed with the acid solution, H₂O₂ and alcohol; and the temperature of the stabilizing solution is 25°C ∼ 600°C.

17. The method of Claim 13 or 15, wherein the stabilizing gas of said stabilizing gas atmosphere of said step (d) is one or a mixture of N₂, O₂, and Ar, and the temperature of said stabilizing gas atmosphere is 25°C ∼ 600°C.

18. The method of Claim 13 or 15, wherein said stabilizing HF-mixed solution of said step (b) is a solution which is mixed with the HF-mixed solution and the stabilizing solution, said stabilizing solution is one or a mixture of an acid solution, a solution mixed with the acid solution, H₂O₂ and alcohol, and the temperature of the stabilizing solution is 25°C ∼ 600°C; and
the stabilizing gas of said stabilizing gas atmosphere of said step (d) is one or a mixture of N₂, O₂, and Ar, and the temperature of said stabilizing gas atmosphere is 25°C ∼ 600°C.
